# EUROPÄISCHE PATENTANMELDUNG

(11) **EP 2 309 367 A1**
(43) Veröffentlichungstag der Anmeldung: **13.04.2011**
(21) Anmeldenummer: 10013299.2
(22) Anmeldetag: 05.10.2010
(51) Int. Cl.: G06F 3/042, H03K 17/96, G06F 3/048, F24C 7/08, D06F 39/00

(54) **Bedienvorrichtung für ein elektronisches Haushaltsgerät**

(30) Priorität: 07.10.2009 DE 102009048546
(71) Anmelder: Diehl AKO Stiftung & Co. KG, 88239 Wangen (DE)
(72) Erfinder: Hammelsbacher, Karlheinz, 91189 Rohr (DE)
(74) Vertreter: Diehl Patentabteilung

(57) **Zusammenfassung**

Eine Bedienvorrichtung für ein elektronisches Haushaltsgerät umfasst ein Anzeigefeld (10), in dem Anzeigefeld (10) ein Positionszeiger (12) darstellbar ist, und ein mit dem Anzeigefeld gekoppeltes, berührungsempfindtiches Eingabefeld (14), das eine Vielzahl von optischen Sensoren (18), die zweidimensional in dem Eingabefeld angeordnet und gegenseitig zumindest teilweise abgeschirmt sind, zum Steuern des Positionszeigers (12) in dem Anzeigefeld (14) aufweist.

## Beschreibung

Die vorliegende Erfindung betrifft eine Bedienvorrichtung für ein elektronisches Haushaltsgerät nach dem Oberbegriff des Anspruchs 1.

Derartige Bedienvorrichtungen weisen wenigstens ein Anzeigefeld und wenigstens ein berührungsempfindliches Eingabefeld auf, welche üblicherweise hinter einer zumindest teilweise lichtdurchlässigen Bedienblende angeordnet sind. Für die berühmngsempfindlichen Eingabefelder sind Systeme mit optischen Sensoren, kapazitiven Sensorelementen, Piezoelementen und induktiven Sensorelementen bekannt.

Je nach Art des Haushaltsgeräts und der über die Bedienvorrichtung zu steuernden Funktionalitäten sind im Stand der Technik sowohl punktuelle Eingabefelder mit einem Sensor als auch eindimensionale Eingabefelder mit einer Reihe von Sensoren bekannt.

Der grundsätzliche Aufbau eines optischen Tastschalters für ein punktuelles Eingabefeld ist zum Beispiel in der DE 40 07 971 A1 beschrieben. Der berührungsempfindliche Tastschalter weist einen elektromagnetische Strahlung aussendenden Sender und einen elektromagnetische Strahlung empfangenden Empfänger auf, die hinter einer für die elektromagnetische Strahlung zumindest teildurchlässigen Abdeckung angeordnet sind.

Die DE 10 2004 042 657 A1 offenbart eine Bedienvorrichtung mit einem eindimensionalen berührungsempfindlichen Eingabefeld. Das Eingabefeld umfasst mehrere IR-Sensoren, die entlang einer geraden oder kreisförmigen Linie angeordnet sind und einen Schieberegler zum Eingeben eines Stellwerts bilden. Es ist eine Aufgabe der Erfindung, eine verbesserte Bedienvorrichtung für Haushaltsgeräte zu schaffen, die im Vergleich zu den herkömmlichen Medienvorrichtungen erweiterte Eingabemöglichkeiten bietet.

Diese Aufgabe wird gelöst durch eine Bedienvorrichtung für Haushaltsgeräte mit den Merkmalen des Anspruchs 1. Vorteilhafte Ausgestaltungen und Weiterbildungen der Erfindung sind Gegenstand der abhängigen Ansprüche.

Die Bedienvorrichtung für ein elektronisches Haushaltsgerät umfasst ein Anzeigefeld und ein mit dem Anzeigefeld gekoppeltes, berührungsempfindliches Eingabefeld und ist erfindungsgemäß dadurch gekennzeichnet, dass in dem Anzeigefeld ein Positianszeiger darstellbar ist und das Eingabefeld eine Vielzahl von optischen Sensoren, die zweidimensional in dem Eingabefeld angeordnet und gegenseitig zumindest teilweise abgeschirmt sind, zum Steuern des Positionszeigers in dem Anzeigefeld aufweist.

Gemäß der Erfindung ist in dem Anzeigefeld ein Positionszeiger darstellbar und das Eingabefeld weist eine Vielzahl von optischen Sensoren auf, die zweidimensional in dem Eingabefeld angeordnet und gegenseitig zumindest teilweise abgeschirmt sind, um den Positionszeiger im Anzeigefeld zu steuern. Durch die zweidimensionale Anordnung der optischen Sensoren lassen sich die Eingabe- und Steuerungsmöglichkeiten im Vergleich zu herkömmlichen punktuellen oder eindimensionalen Eingabefeldern deutlich erweitern.

Das mit optischen Sensoren bestückte Eingabefeld bildet für den Benutzer ein Touch Pad nach, wie es zum Beispiel von Notebooks bekannt ist. Der Benutzer ist daher mit der Bedienung der hier vorgeschlagenen Bedienvorrichtung sofort vertraut.

Während die Touch Pads bei Notebooks üblicherweise mit kapazitiven Sensorelementen oder Piezoelementen bestückt sind, kommen in dem berührungsempfindlichen Eingabefeld der erfindungsgemäßen Bedienvorrichtung optische Sensoren zum Einsatz, da diese im Allgemeinen nicht oder nur kaum feuchteempfindlich sind. Dies ist bei Bedienvorrichtungen für elektronische Haushaltsgeräte ein entscheidender Vorteil.

Die optischen Sensoren des Eingabefeldes sind gegenseitig zumindest teilweise abgeschirmt, um ein wechselseitiges Übersprechen zu verhindern und einen Fremdlichteinfall zumindest zu minimieren. Nur auf diese Weise können die zweidimensionale Funktionalität und eine ausreichende Auflösung des Eingabefeldes gewährleistet werden.

Die Bedienvorrichtung umfasst ein Anzeigefeld und ein Eingabefeld, d.h. wenigstens ein Anzeigefeld und wenigstens ein Eingabefeld. Die Anzeige- und Eingabefelder können dabei grundsätzlich in beliebiger Konfiguration nebeneinander angeordnet sein. Auch können die Anzeige- und Eingabefelder wahlweise eine Einheit bilden oder separat voneinander positioniert sein.

Die Bedienvorrichtung der Erfindung ist allgemein für elektronische Haushaltsgeräte geeignet. Zu den elektronischen Haushaltsgeräten zählen insbesondere Kochherde, Mikrowellenherde, Kochfelder bzw. Kochmulden, Waschmaschinen, Wäschetrockner, Waschtrockner, Spülmaschinen und dergleichen.

Auf dem Anzeigefeld der erfindungsgemäßen Bedienvorrichtung können verschiedene Funktionalitäten des jeweiligen Haushaltsgeräts, deren aktuell eingegebene Stellwerte, aktuelle Messwerte, aktuelle Betriebszustände und dergleichen dargestellt werden.

Der Positionszeiger im Anzeigefeld ist zum Beispiel als Mauszeiger bzw. Cursor konzipiert wie er aus der Computertechnik bekannt ist, wobei auch bei der erfindungsgemäßen Bedienvorrichtung zahlreiche verschiedene Darstellungsvarianten denkbar sind.

In einer bevorzugten Ausgestaltung der Erfindung ist das Anzeigefeld als eine LCD-Anzeige ausgebildet.

Die optischen Sensoren sind vorzugsweise Infrarot (IR) - Sensoren mit entsprechenden IR-Sendern und IR-Empfängern. Für das berührungsempfindliche Eingabefeld der erfindungsgemäßen Bedienvorrichtung können aber ganz allgemein optische Sensoren mit elektromagnetische Strahlung aussendenden Sendern und elektromagnetische Strahlung empfangenden Empfängern verwendet werden.

In einer weiteren Ausgestaltung der Erfindung ist das berührungsempfindliche Eingabefeld mit einer Auslösefunktionalität versehen. Bei dieser Ausführungsform besteht wie bei einem Touch Pad eines Notebooks die Möglichkeit, den Positionszeiger in dem Anzeigefeld zunächst zu einer gewünschten Position zu bewegen und dann mittels der Auslösefunktionalität eine entsprechende Funktion im Anzeigefeld bzw. im Haushaltsgerät auszulösen.

Diese wenigstens eine Auslösefunktionalität kann zum Beispiel als ein berührungsempfindlicher Tastschalter mit wenigstens einem optischen Sensor (z.B. IR-Sensor) ausgebildet sein.

Obige sowie weitere Merkmale, Vorteile und Anwendungsmöglichkeiten der Erfindung werden aus der nachfolgenden Beschreibung eines bevorzugten, nichteinschränkenden Ausführungsbeispiels anhand der beiliegenden Zeichnungen besser verständlich. Darin zeigen:
- Fig. 1: eine stark vereinfachte schematische Darstellung des Aufbaus einer Bedienvorrichtung für ein elektronisches Haushaltsgerät gemäß einem Ausführungsbeispiel der vorliegenden Erfindung; und
- Fig. 2: eine stark vereinfachte schematische Darstellung des Aufbaus des berührungsempfindlichen Eingabefeldes der Bedienvorrichtung von Fig. 1.

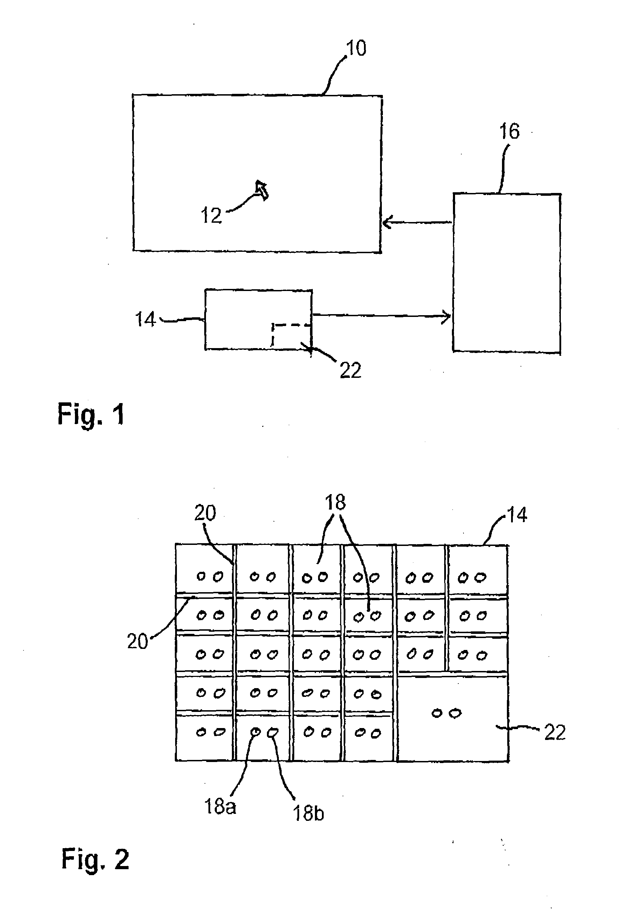

Bezug nehmend auf Fig. 1 und 2 wird nun ein Ausführungsbeispiel einer Bedienvorrichtung für ein elektronisches Haushaltsgerät wie beispielsweise eines Kochherdes, eines Mikrowellenherdes, eines Kochfeldes bzw. einer Kochmulde, einer Waschmaschine, eines Wäschetrockners, eines Waschtrockners, einer Spülmaschine oder dergleichen in mehr Einzelheiten beschrieben.

Die Bedienvorrichtung umfasst ein Anzeigefeld 10 in Form einer LCD-Anzeige oder dergleichen. Auf diesem Anzeigefeld 10 werden für den Benutzer zum Beispiel die einzelnen Kochfelder eines Kochfeldes dargestellt, gemeinsam mit den Anzeigen ihres Betriebszustandes (ein/aus), ihrer eingestellten Kochstufe (z_B. 1 ... 9), ihrer Restkochzeit, ihrer Kochfeldgröße (bei variablen Kochfeldem), ihres Kochprogramms und dergleichen.

Ferner wird in dem Anzeigefeld 10 ein Positionszeiger 12 dargestellt. Dieser hat zum Beispiel die Grafik eines üblichen Mauszeigers bzw. Cursors, wie er von Computerbildschirmen bekannt ist, wie in Fig. 1 angedeutet.

Neben diesem Anzeigefeld 10 ist ein berührungsempfindliches Eingabefeld 14 vorgesehen. Im Fall von Fig. 1 ist dieses Eingabefeld 14 unterhalb des Anzeigefeldes 10 und separat zu diesem positioniert, ohne dass die Erfindung auf diese gegenseitige Anordnung beschränkt sein soll. Insbesondere kann das Eingabefeld 14 auch rechts oder links neben dem Anzeigefeld 10 positioniert werden und/oder mit dem Anzeigefeld 10 eine Einheit bilden.

Auch ist die Größe des Eingabefeldes 14 bzw. sein Größenverhältnis zum Anzeigefeld 10 prinzipiell beliebig. Im Allgemeinen sollte aber ein Eingabefeld 14 ausreichen, welches kleiner als das Anzeigefeld 10 konzipiert ist.

Das berührungsempfindliche Eingabefeld 14 ist über eine Steuer- und Auswerteeinrichtung 16 mit dem Anzeigefeld 10 gekoppelt. Diese Steuer- und Auswerteeinrichtung 16 erfasst insbesondere Berührungen des Eingabefeldes 14 bzw. Bewegungen über das Eingabefeld 14 hinweg und setzt diese in entsprechende Bewegungen bzw. Positionierungen des Positionszeigers 12 innerhalb des Anzeigefeldes 10 um.

Mit Hilfe der Steuer- und Auswerteeinrichtung 16 können ggf. auch die Darstellungen im Anzeigefeld 10 gewechselt werden, zum Beispiel unterschiedliche Darstellungsebenen eines Menüs angezeigt werden. Die unterschiedlichen Darstellungsebenen können in diesem Fall mit Hilfe des durch das Eingabefeld 14 gesteuerten Positionszeigers 12 angewählt werden.

Darüber hinaus steuert die Steuer- und Auswerteeinrichtung 16 auch die Anzeigen des Anzeigefeldes 10 und ggf. auch direkt das elektronische Haushaltsgerät, in dem diese Bedienvorrichtung eingebaut ist.

Die Bedienvorrichtung kann auch zwei oder mehr Anzeigefelder 10 enthalten, die durch ein, zwei oder mehr Eingabefelder 14 gesteuert werden können. Die Kopplung dieser größeren Anzahl von Anzeige- und Eingabefeldern 10, 14 erfolgt vorzugsweise über eine gemeinsame Steuer und Auswerteeinrichtung 16. Es ist dabei auch möglich, mehrere Anzeigefelder 10 mittels nur eines Eingabefeldes 14 anzusteuern.

Das berührungsempfindliche Eingabefeld 14 enthält eine Vielzahl von optischen Sensoren, insbesondere von IR-Sensoren 18. Wie in Fig. 2 veranschaulicht, sind diese optischen Sensoren 18 zweidimensional, d.h. zum Beispiel in Reihen und Spalten bzw. matrixartig, angeordnet. Wie bei einem Touch Pad eines Notebooks können diese IR-Sensoren 18 das Vorhandensein zum Beispiel eines Fingers bzw. einer Fingerspitze auf dem Eingabefeld 14 und insbesondere eine Bewegung des Fingers über das Eingabefeld 14 hinweg erkennen. Die so erkannte Bewegung wird von der Steuer- und Auswerteeinrichtung 16 in eine entsprechende Verschiebung des Positionszeigers 12 im Anzeigefeld 10 umgesetzt.

Die einzelnen IR-Sensoren 18 umfassen jeweils wenigstes einen IR-Sender 18a und wenigstens einen IR-Empfänger 18b. Aufbau und Funktionsweise eines solchen IR-Sensors 18 sind dem Fachmann hinlänglich bekannt; nur beispielhaft wird an dieser Stelle nochmals auf die bereits eingangs genannte DE 40 07 971 A1 verwiesen.

Die Anzahl der IR-Sensoren 18 ist in Fig. 2 der besseren Übersichtlichkeit halber stark begrenzt.

Diese optischen Sensoren 18 des Eingabefeldes 14 sind hinter einer zumindest teilweise lichtdurchlässigen Abdeckung zum Beispiel aus Glas oder Glaskeramik angeordnet.

Um ein Übersprechen zwischen benachbarten IR-Sensoren 18 zu verhindern und einen Fremdlichteinfall auf die IR-Empfänger 18b der Sensoren 18 zu minimieren, sind die IR-Sensoren 18 mittels geeigneter, lichtundurchlässiger Blendenelemente 20 gegenseitig zumindest teilweise abgeschirmt.

Zur weiteren Verbesserung der Eingabemöglichkeriten für den Benutzer weist das Eingabefeld 14 in einer bevorzugten Ausführungsform ferner wenigstens eine Auslösefunktionalität in Form eines berührungsempfindlichen, optischen Tastschalters 22 auf. In bevorzugter Ausführungsform weist der optische Tastschalter ebenfalls wenigstens einen optischen Sensor, insbesondere wenigstens einen IR-Sensor auf. Dieser optische Tastschalter 22 ist für den Benutzer optisch gekennzeichnet und/oder vom übrigen Eingabefeld abgesetzt, sodass er für den Benutzer einfach und eindeutig erkennbar ist.

Dieser Tastschalter 22 dient zum Beispiel dem Anwählen und Eingeben, d.h. dem Auslösen einer Funktion an der Position des Positionszeigers 12 im Anzeigefeld 10. Diese Auslösefunktionalität entspricht im Wesentlichen den Drucktasten oder Tastschaltern der von Notebooks bekannten Touch Pads.

In einer besonders bevorzugten Ausführungsform lässt sich die Tastfunktion durch ein- oder mehrmaliges Tippen auf das Eingabefeld 14 auslösen, wodurch eine einfache Bedienung ermöglicht wird.

## Patentansprüche

1. Bedienvorrichtung für ein elektronisches Haushaltsgerät, mit einem Anzeigefeld (10) und einem mit dem Anzeigefeld gekoppelten, berührungsempfindlichen Eingabefield (14),
**dadurch gekennzeichnet,**
**dass** in dem Anzeigefeld (10) ein Positionszeiger (12) darstellbar ist; und dass das Eingabefeld (14) eine Vielzahl von optischen Sensoren (18), die zweidimensional in dem Eingabefeld angeordnet und gegenseitig zumindest teilweise abgeschirmt sind, zum Steuern des Positionszeigers (12) in dem Anzeigefeld (14) aufweist.

2. Bedienvorrichtung nach Anspruch 1,
**dadurch gekennzeichnet,**
**dass** das Anzeigefeld (10) als eine LCD-Anzeige ausgebildet ist.

3. Bedienvorrichtung nach Anspruch 1 oder 2,
**dadurch gekennzeichnet,**
**dass** die optischen Sensoren (18) des Eingabefeldes (14) IR-Sensoren sind.

4. Bedienvorrichtung nach einem der Ansprüche 1 bis 3,
**dadurch gekennzeichnet,**
**dass** das berührungsempfindliche Eingabefeld (14) mit wenigstens einer Auslösefunktionalität (22) versehen ist.

5. Bedienvorrichtung nach Anspruch 4,
**dadurch gekennzeichnet,**
**dass** die wenigstens eine Auslösefunktionalität (22) als ein berührungsempfindlicher Tastschalter mit wenigstens einem optischen Sensor ausgebildet ist.
